# EUROPÄISCHE PATENTSCHRIFT

(11) **EP 1 985 162 B1**
(45) Veröffentlichungstag und Bekanntmachung des Hinweises auf die Patenterteilung: **01.09.2010**
(21) Anmeldenummer: 07703261.3
(22) Anmeldetag: 05.02.2007
(51) Int. Cl.: H05K 1/18, H05K 3/30, H05K 7/14, H01R 12/24

(54) **HALTER FÜR EINE FLEXIBLE LEITERPLATTE**
HOLDER FOR A FLEXIBLE CIRCUIT BOARD
SUPPORT POUR UNE CARTE DE CIRCUITS IMPRIMÉS FLEXIBLE

(30) Priorität: 09.02.2006 DE 102006005941
(43) Veröffentlichungstag der Anmeldung: 29.10.2008
(73) Patentinhaber: KNORR-BREMSE Systeme für Nutzfahrzeuge GmbH, 80809 München (DE)
(72) Erfinder: KLINGER, Herbert, 90455 Nürnberg (DE); THOMAS, Gerhard, 90768 Fürth (DE); HOFMANN, Norbert, 91056 Erlangen (DE); PETRZIK, Martin, 90547 Stein (DE); DELFS, Joachim, 71282 Hemmingen (DE)
(74) Vertreter: Mattusch, Gundula
(86) Internationale Anmeldenummer: PCT/EP2007/000951
(87) Internationale Veröffentlichungsnummer: WO 2007/090589

(56) Entgegenhaltungen:
- DE-A1- 10 061 866
- US-A- 3 774 140
- US-A- 5 669 775
- US-A1- 2005 266 704

## Beschreibung

Die vorliegende Erfindung betrifft einen Halter mit einer Vorrichtung zur Halterung einer flexiblen Leiterplatte.

Ein Halter gemäß dem Oberbegriff von Anspruch 1 wird in DE 10 061 866 A1 gezeigt.

Elektrische Verbindungen zwischen und innerhalb von komplexen Baugruppen werden in zunehmendem Maße mit flexiblen Leiterplatten, auch Flexfolien genannt, realisiert. Diese weisen gegenüber elektrischen Kabelverbindungen eine Reihe von Vorteilen auf. Eine flexible Leiterplatte ermöglicht eine gute Beweglichkeit von Komponenten der Baugruppen zueinander, insbesondere auch während der Montage. Des weiteren nimmt eine flexible Leiterplatte im Vergleich zu konventionellen Kabeln ein geringeres Volumen ein und kann gleichzeitig höheren mechanischen Beanspruchungen ausgesetzt werden. Mit einer flexiblen Leiterplatte werden beispielsweise verschiedene elektronische Komponenten, wie etwa Sensoren, Aktuatoren, etc. mit einer Steuer- oder Regelelektronik elektrisch verbunden. Für die elektrische Anbindung derartiger elektronischer oder mechatronischer Komponenten an die flexible Leiterplatte und für die Halterung der flexiblen Leiterplatte selbst sind im Stand der Technik verschiedene Halter bekannt. Beispielsweise existieren Halter, die eine Zugentlastung für die flexible Leiterplatte bei Montage und Betrieb von zueinander beweglichen mechanischen beziehungsweise elektronischen Komponenten vorsehen.

Der Erfindung liegt die Aufgabe zugrunde, einen Halter für flexible Leiterplatten zur Verfügung zu stellen, der eine besonders einfache und kostengünstige Montage der flexiblen Leiterplatte und der mit ihr verbundenen Bauteile ermöglicht.

Diese Aufgabe wird mit den Merkmalen des unabhängigen Anspruchs gelöst.

Vorteilhafte Ausführungsformen der Erfindung sind in den abhängigen Ansprüchen angegeben.

Die Erfindung baut auf den gattungsgemäßen Halterungen für flexible Leiterplatten dadurch auf, dass der Halter mindestens eine weitere Vorrichtung zur Halterung mindestens eines Bauteils aufweist, wobei das Bauteil mit der flexiblen Leiterplatte verbindbar ist. Es hat sich als vorteilhaft herausgestellt, an dem Halter für die flexible Leiterplatte Haltevorrichtungen für weitere Bauteile vorzusehen, die mit der flexiblen Leiterplatte zu verbinden sind. Dies reduziert bei der Herstellung und der nachfolgenden Montage die Anzahl an Halterungen, was insgesamt die Herstellungskosten senkt. Des Weiteren befindet sich das Bauteil beziehungsweise die weiteren Bauteile bereits in der direkten Umgebung der flexiblen Leiterplatte, mit der sie zu verbinden sind. Dies reduziert die erforderliche Länge der Verbindungswege, erleichtert die Anordnung der zu verbindenden Bauteile und spart zusätzliche Verbindungselemente zwischen Leiterplatte und Bauteil.

Bei einer ebenfalls bevorzugten Ausführungsform ist vorgesehen, dass das Bauteil einen elektrischen Anschluss bildet. Dies kann beispielsweise der elektrische Anschluss eines Sensors, eines Aktuators oder anderer elektrischer Komponenten sein, die mit der flexiblen Leiterplatte elektrisch zu verbinden sind. Somit besteht an dem Halter die Möglichkeit, einzelne Komponenten der Baugruppen mittels des Bauteils mit der flexiblen Leiterplatte selbst zu verbinden. Auf diese Weise können eventuell bei der Montage oder im Betrieb auftretende mechanische oder thermische Belastungen von dem Bauteil aufgenommen werden, das im Vergleich zur flexiblen Leiterplatte in dieser Hinsicht meist besser angepasst werden kann.

Bei einer alternativen Ausführungsform kann vorgesehen sein, dass das Bauteil ein aktives Bauelement bildet. Eine kurze Verbindung zwischen dem Bauelement und der flexiblen Leiterplatte ist insbesondere im Fall von aktiven Bauelementen von Vorteil.

Es kann außerdem vorteilhaft vorgesehen sein, dass das aktive Bauelement ein Sensor ist. Insbesondere Sensoren profitieren von besonders kurzen Verbindungswegen, da oft nur geringe Signalhöhen vorhanden sind und/oder durch lange Verbindungswege unerwünschte Störsignale dem Messsignal aufgeprägt werden können.

Bei einer ebenfalls bevorzugten Ausführungsform ist vorgesehen, dass der Sensor ein Weg-, ein Drehzahl- und/oder ein Temperatursensor ist. Beispielsweise kann ein aktives Bauelement, das aus einer Kombination aus einem Drehzahlfühler und einem Temperatursensor besteht, an dem Halter befestigt werden und dessen Steckanschluss mit der flexiblen Leiterplatte verbunden werden.

Bei einer vorteilhaften Ausführungsform kann vorgesehen sein, dass das Bauteil ein Stanzgitter aufweist. Insbesondere kann auf diese Weise die Halterung und Positionierung von eingespritzten Stanzgitterenden eines Sensors vorteilhaft durchgeführt werden.

Es kann ebenfalls in vorteilhafter Weise vorgesehen sein, dass das Bauteil eine Zugentlastung aufweist. Eine derartige Zugentlastung kann in mehreren Anwendungsfällen von Vorteil sein. Beispielsweise kann die flexible Leiterplatte bei ihrer Kontaktierung mit einer Elektronik selbst einer Zugentlastung bedürfen. Darüber hinaus sind aber auch die weiteren auf dem Halter befestigbaren Bauteile oft sowohl bei der Montage als auch im Betrieb mit mechanisch belasteten Komponenten verbunden. In diesem Fall sind ebenfalls an dem Bauteil Vorrichtungen vorsehbar, die Zugkräfte beispielsweise an Kabeln, umspritzten Stanzgitterenden, etc. aufnehmen.

In analoger Weise kann bei einer vorteilhaften Ausführungsform vorgesehen sein, dass das Bauteil einen Knickschutz zur Verfügung stellt. Vorzugsweise lassen sich sogar Zugentlastung und Knickschutz in einer einzigen geeigneten Form des Bauteils realisieren.

Des Weiteren kann bei einer ebenfalls bevorzugten Ausführungsform vorgesehen sein, dass die weitere Vorrichtung die Position des Bauteils in Bezug auf den Halter im Wesentlichen festlegt. Insbesondere bei direkt elektrisch mit der flexiblen Leiterplatte zu verbindenden Bauteilen stellt ein Festlegen der Position des zweiten Bauteils relativ zu dem Halter und damit auch relativ zu der flexiblen Leiterplatte einen Vorteil dar. Es entfällt damit ein weiterer Positionierschritt, der gemäß dem Stand der Technik notwendig wäre. Darüber hinaus ergibt sich im Betrieb der gesamten Baugruppe eine höhere Zuverlässigkeit, da sich bei einer entsprechenden Ausgestaltung des Halters die Position zwischen flexibler Leiterplatte und Bauteil nicht verändern kann.

Eine ebenfalls vorteilhafte Ausführungsform sieht vor, dass die mittels der weiteren Vorrichtung geschaffene Verbindung zwischen dem Bauteil und dem Halter lösbar ist. Dies ist insbesondere unter dem Aspekt der Montage beziehungsweise Reparatur von Vorteil.

Insbesondere sieht eine ebenfalls vorteilhafte Ausführungsform vor, dass die weitere Vorrichtung eine Rast- und/oder Steckvorrichtung ist. Dies erleichtert bei der Montage und bei Reparatur- beziehungsweise Austauscharbeiten den Einbau des Bauteils.

Eine weitere, ebenfalls vorteilhafte Ausführungsform, ist dadurch gekennzeichnet, dass das Bauteil eine Führung für elektrische Verbindungen aufweist. Dies kann insbesondere bei Montage- und Reparaturarbeiten die Handhabung des Bauteils und der Verbindungen erleichtern.

Der Erfindung liegt die Erkenntnis zugrunde, dass in einem zentralen Halterungs- beziehungsweise Trageelement mehrere Funktionen in einem Teil vereint werden können, die herkömmlich von mehreren separaten Teilen übernommen werden. Dabei übernimmt das zentrale Trageelement folgende Funktionen: Es hält und fixiert eine flexible Leiterplatte, und es bildet eine Zugentlastung sowie einen Knickschutz der flexiblen Leiterplatte bei Kontaktierung mit einer Elektronik. Des Weiteren übernimmt das Trageelement die Halterung und Positionierung von Anschlüssen, insbesondere eines Steckanschlusses eines Sensors, und führt die flexible Leiterplatte diesem Sensor zu. Weiterhin können auch Kabel- und Stanzgitteranschlüsse von Sensoren an diesem Trageelement gehaltert und positioniert werden.

Die Erfindung wird nun mit Bezug auf die begleitenden Zeichnungen anhand bevorzugter Ausführungsformen beispielhaft erläutert.

Dabei zeigen:
- Figur 1: eine Schnittansicht einer ersten bevorzugten Ausführungsform des erfindungsgemäßen Halters; und
- Figur 2: eine Detailschnittansicht einer zweiten ebenfalls bevorzugten Ausführungsform.

Bei der nachfolgenden Beschreibung der Zeichnungen bezeichnen gleiche Bezugszeichen gleiche oder vergleichbare Komponenten.

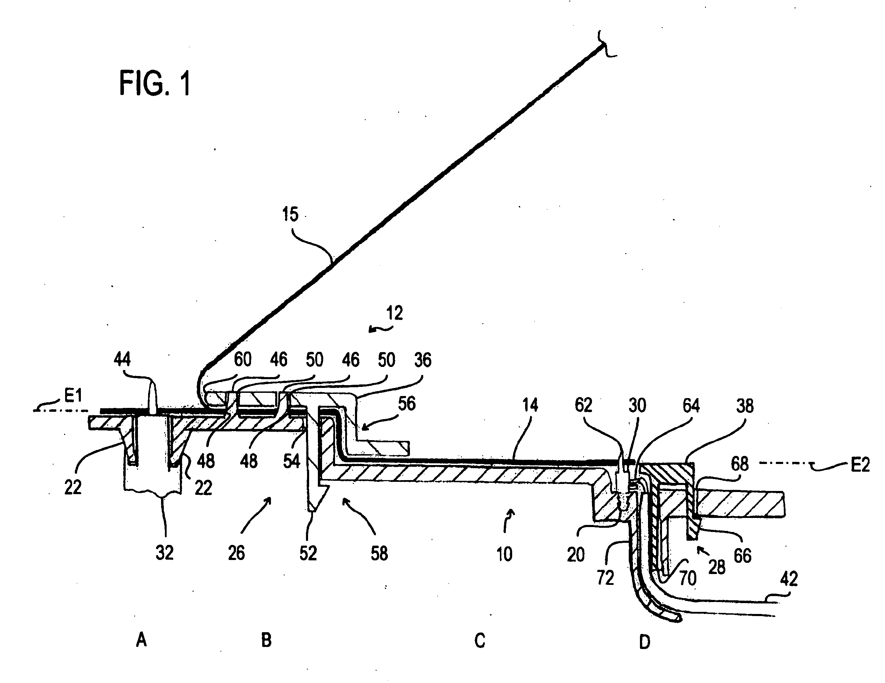

Figur 1 zeigt eine Schnittansicht einer ersten bevorzugten Ausführungsform des erfindungsgemäßen Halters 10. Der zentrale, aus Kunststoff gefertigte Halter 10 dient der Halterung der flexiblen Leiterplatte 14 und weiterer Bauteile, wie im Folgenden erläutert wird. Der zentrale Kunststoffhalter 10 lässt sich zu Erläuterungszwecken in vier Abschnitte A, B, C und D unterteilen. In den Abschnitten A und B verläuft die flexible Leiterplatte 14 im Wesentlichen in einer ersten Ebene E1, in den Abschnitten C und D hingegen in einer zweiten, tiefer gelegenen Ebene E2.

Im Abschnitt A weist der zentrale Kunststoffhalter 10 eine Sensorhalterung 22 auf. In diese Sensorhalterung 22 ist ein aktives Bauelement 32 einbracht, von dem aus Darstellungsgründen nur ein oberer Teil abgebildet ist. Das aktive Bauelement 32 ist ein kombinierter Drehzahl- und Temperatursensor. Das aktive Bauelement 32 weist einen Kontaktpin 44 auf, über den zwischen dem aktiven Bauelement 32 und der flexiblen Leiterplatte 14 eine elektrische Kontaktierung hergestellt werden kann.

Im Abschnitt B ist an dem zentralen Kunststoffhalter 10 eine Zugentlastungsvorrichtung 26 als Bestandteil der Halterungsvorrichtung 12 vorgesehen, da die die flexible Leiterplatte 14 neben ihren im Wesentlichen parallel zu dem zentralen Kunststoffhalter 10 verlaufenden Bereichen einen freien Bereich 15 aufweist, der zu einer Elektronikeinheit (nicht abgebildet) führt. Die Zugentlastungsvorrichtung 26 weist Vorsprünge 46 auf, die in entsprechend gestaltete Aussparungen 48 der flexiblen Leiterplatte 14 greifen. Mit der Zugentlastungsvorrichtung 26 wirkt ein Rastteil 36 zusammen. Dieses Rastteil 36 weist Ausnehmungen 50 auf, die mit den Vorsprüngen 46 der Zugentlastungsvorrichtung 26 in Durchmesser und Anordnung zumindest im Wesentlichen korrespondieren. Das Rastteil 36 weist weiter eine Rastnase 52, die in einen Durchbruch 54 des zentralen Kunststoffhalters 10 greift, sowie einen Knickschutzabschnitt 60 auf. In der Querschnittsansicht entspricht die Form des Rastteils 36 in seinem Bereich 56 der Form des zentralen Kunststoffhalters 10 in dessen Bereich 58, d. h. Rastteil 36 und zentraler Kunststoffträger verlaufen dort weitgehend parallel.

Bei der Montage der flexiblen Leiterplatte 14 auf den zentralen Kunststoffhalter 10 wird die flexible Leiterplatte 14 mit ihren Ausnehmungen 48 hinsichtlich der Vorsprünge 46 ausgerichtet und auf den zentralen Kunststoffträger 10 aufgebracht. Anschließend wird das Rastteil 36 bezüglich seiner Ausnehmungen 50 mit den Vorsprüngen 46 ausgerichtet. Anschließend wird die Rastnase 52 durch die Durchführung 54 geführt und somit mit dem zentralen Kunststoffhalter 10 verrastet. Dabei wird auf die flexible Leiterplatte 14 ein Druck ausgeübt, der sich auf die gesamte, von dem Rastteil 46 bedeckte Oberfläche der flexiblen Leiterplatte 14 erstreckt. Auf diese Weise wird zum einen eine Zugentlastung für eventuell am freien Ende 15 der flexiblen Leiterplatte 14 auftretende Kräfte bereitgestellt. Zum anderen wird der Verlauf der flexiblen Leiterplatte 14 entlang des zentralen Kunststoffhalters 10 festgelegt und so insbesondere ein Ebenenwechsel der flexiblen Leiterplatte 14 von der Ebene E1 in die Ebene E2 aufgrund des Zusammenwirkens von Abschnitt 56 des Rastteils 36 und des Bereichs 58 des zentralen Kunststoffhalters 10 bewirkt. Der geeignet gewählte Krümmungsradius des Rastteils 36 an dessen Knickschutzabschnitt 60 wirkt gleichzeitig einem unerwünschtes Abknicken der flexiblen Leiterplatte 14 bei eventuell auftretenden Zugkräften im freien Bereich 15 der flexiblen Leiterplatten 14 entgegen.

In Abschnitt C wird die flexible Leiterplatte 14 parallel zum zentralen Kunststoffhalter 10 geführt, und sie verbindet so die Bereiche B und D.

In Abschnitt D ist in dem zentralen Kunststoffhalter 10 eine Steckvertiefung 20 vorgesehen. In diese Steckvertiefung 20 kann eine Übergabeeinheit 30 eingebracht werden. Diese weist einen Kontaktpin 62 an ihrer Oberseite sowie seitlich angebrachte Kontaktflächen 64 zum Anlöten einer Litze oder eines Pins einer elektromechanischen Komponente auf. Die Übergabeeinheit 30 kann mit ihrer Unterseite in die Steckvertiefung 20 eingebracht und somit befestigt werden. Dies kann, wie abgebildet, beispielsweise bei einer entsprechend gewählten Materialkombination durch eine geeignete sägezahnartige Außenkonturierung unterstützt werden. Des Weiteren ist in Abschnitt D ein Rastkeil 38 zusammen mit einer Kabelführungsvorrichtung 28 des zentralen Kunststoffhalters 10 vorgesehen. Der Rastkeil 38 weist in Analogie zum Rastteil 36 eine Rastnase 66 auf, die in die Rastdurchführung 68 eingebracht und dort verrastet werden kann. Außerdem weist der Rastkeil 38 einen sich verbreiternden keilförmigen Abschnitt 70 auf. Dieser wirkt mit einem Kabelführungsabschnitt 72 des zentralen Kunststoffhalters 10 zusammen. In diesem Kabelführungsabschnitt 72 werden beispielsweise die Sensoranschlusskabel 42 zur Übergabeeinheit 30 geführt. Nach Einbringen des Rastkeils 38, insbesondere des keilförmigen Abschnitts 70 in die Kabelführungsvorrichtung 28 wird eine Klemmung der Sensoranschlusskabel 42 innerhalb des Kabelführungsabschnitts 72 bewirkt, was eine Positionierung und Zugentlastung für die Sensoranschlusskabel 42 darstellt.

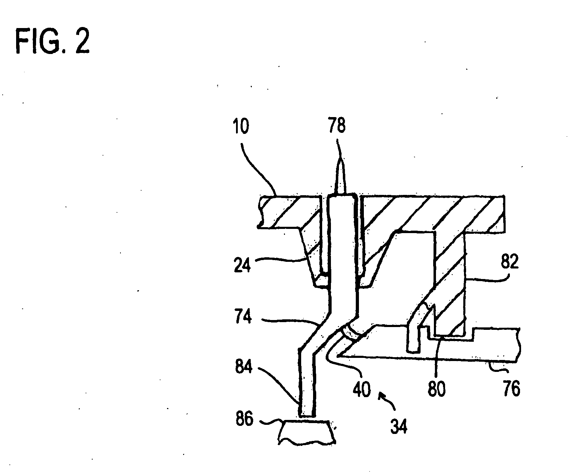

Die Figur 2 zeigt eine Detailschnittansicht einer zweiten, ebenfalls bevorzugten Ausführungsform. In dieser Detailschnittansicht ist für den Abschnitt D eine alternative Ausführungsform des zentralen Kunststoffhalters 10 dargestellt. Anstelle einer Zuführung der Sensoranschlüsse mittels eines Kabels, wie in Figur 1 abgebildet, ist in dieser Ausführungsform die Zuleitung der Sensoranschlüsse über ein umspritztes Stanzgitter 34 realisiert. Das umspritzte Stanzgitter 34 umfasst zwei Sensorarme 74, 76, die zueinander beweglich über einen freiliegenden Stanzgitterabschnitt 40 ausgestaltet sind. Der während der Montage, wie in Figur 2 dargestellt, nach oben um neunzig Grad hochgebogene Sensorarm 74 weist einen Kontaktpin 78 auf, der mit der flexiblen Leiterplatte 14 verlötet werden kann. An dem waagrecht verbleibenden Sensorarm 76 ist eine Nut 80 vorgesehen, in die eine Kunststoffrippe 82 des zentralen Kunststoffhalters 10 zur Stabilisierung und Fixierung des Sensorarms 76 greift. Das Stanzgitterende 74 wird in einer Halterung 24 des zentralen Kunststoffhalters 10 positioniert und gehaltert. Weiterhin weist das Stanzgitterende 74 zudem einen Abstützungsabschnitt 84 auf, der an einer Auflage 86 an einem in Figur 2 lediglich teilweise angedeuteten Druckgussunterteil aufliegt. Dieser Abstützungsabschnitt 84 positioniert den umspritzten Sensoranschluss 34 zusätzlich und stützt ihn ab. Es können auch am waagrechten Sensorarm 76 weitere Auflagen vorgesehen sein.

### Bezugszeichenliste:

- 10: zentraler Kunststoffhalter
- 12: Halterungsvorrichtung
- 14: flexible Leiterplatte
- 15: freies Ende der flexiblen Leiterplatte
- 20: Steckvertiefung
- 22: Sensoraufnahme
- 24: Stanzgitterendehalterung
- 26: Zugentlastungsvorrichtung
- 28: Kabelführungsvorrichtung
- 30: Libergabeeinheit
- 32: aktives Bauelement
- 34: Sensor-Stanzgitter
- 36: Rastteil
- 38: Rastkeil
- 40: freiliegender Stanzgitterabschnitt
- 42: Sensoranschlusskabel
- 44: Kontaktpin
- 46: Vorsprünge
- 48: Ausnehmungen in flexibler Leiterplatte
- 50: Ausnehmungen in Rastteil
- 52: Rastnase
- 54: Rastdurchführung
- 56: Bereich des Ebenenwechsels
- 58: Bereich des Ebenenwechsels
- 60: Knickschutzabschnitt
- 62: Übergabeeinheit Kontaktpin
- 64: Anlötkontaktfläche
- 66: Rastnase
- 68: Rastdurchführung
- 70: keilförmiger Abschnitt
- 72: Kabelführung
- 74: Stanzgitterende
- 76: waagrechter Sensorarm
- 78: Kontaktpin
- 80: Nut
- 82: Kunststoffrippe
- 84: Abstützabschnitt
- 86: Auflage
- A, B, C, D: Abschnitte des zentralen Kunststoffhalters
- E1, E2: Ebenen der flexiblen Leiterplatte

## Patentansprüche

1. Halter (10) mit einer Vorrichtung (12) zur Halterung einer flexiblen Leiterplatte (14), wobei der Halter (10) einteilig ist und mindestens eine weitere Vorrichtung (20-28) zur Halterung mindestens eines Bauteils (30-34) aufweist, das Bauteil (30-34) mit der flexiblen Leiterplatte (14) elektrisch verbindbar ist und die flexible Leiterplatte (14) auf einer Auflagefläche der Vorrichtung (12) zur Halterung der flexiblen Leiterplatte positionierbar ist, **dadurch gekennzeichnet, dass** die weitere Vorrichtung (20-28) und das Bauteil (30-34) auf der selben Seite der Leiterplatte (14) vorgesehen sind, wie die Auflagefläche der Vorrichtung (12) zur Halterung der flexiblen Leiterplatte.

2. Halter (10) nach Anspruch 1, **dadurch gekennzeichnet, dass** das Bauteil (30) einen elektrischen Anschluss bildet.

3. Halter (10) nach Anspruch 1 oder 2, **dadurch gekennzeichnet, dass** das Bauteil (32) ein aktives Bauelement bildet.

4. Halter (10) nach Anspruch 3, **dadurch gekennzeichnet, dass** das aktive Bauelement (32) ein Sensor ist.

5. Halter (10) nach Anspruch 4, **dadurch gekennzeichnet, dass** der Sensor (32) ein Weg-, ein Drehzahl- und/oder ein Temperatursensor ist.

6. Halter (10) nach einem der vorhergehenden Ansprüche, **dadurch gekennzeichnet, dass** das Bauteil (34) ein Stanzgitter (40) aufweist.

7. Halter (10) nach einem der vorhergehenden Ansprüche, **dadurch gekennzeichnet, dass** eine Komponente (36, 38) vorgesehen ist, die eine Zugentlastung (26) aufweist.

8. Halter (10) nach einem der vorhergehenden Ansprüche, **dadurch gekennzeichnet, dass** eine Komponente (36) vorgesehen ist, die einen Knickschutz (60) zur Verfügung stellt.

9. Halter (10) nach einem der vorhergehenden Ansprüche, **dadurch gekennzeichnet, dass** die weitere Vorrichtung (20-28) die Position des Bauteils (30-34) in Bezug auf den Halter (10) im Wesentlichen festlegt.

10. Halter (10) nach einem der Ansprüche 7 bis 9, **dadurch gekennzeichnet, dass** die weitere Vorrichtung (26-28) die Position der Komponente (36, 38) in Bezug auf den Halter (10) im Wesentlichen festlegt.

11. Halter (10) nach einem der Ansprüche 7 bis 9, **dadurch gekennzeichnet, dass** die mittels der weiteren Vorrichtung (26, 28) geschaffene Verbindung zwischen der Komponente (36, 38) und dem Halter (10) lösbar ist.

12. Halter (10) nach einem der vorhergehenden Ansprüche, **dadurch gekennzeichnet, dass** die weitere Vorrichtung (20, 26, 28) eine Rast- (26, 28) und/oder eine Steckvorrichtung (20) ist.

13. Halter (10) nach einem der vorhergehenden Ansprüche, **dadurch gekennzeichnet, dass** die weitere Vorrichtung (28) eine Führung für elektrische Verbindungen (42) aufweist.

14. Halter (10) nach einem der Ansprüche 7 bis 13, **dadurch gekennzeichnet, dass** die Komponente (38) eine Führung für elektrische Verbindungen (72) aufweist.

## Claims

1. A holder (10) with a device (12) for retaining a flexible circuit board (14), it being the case that the holder (10) is in one piece and has at least one further device (20-28) for retaining at least one component (30-34), the component (30-34) can be connected electrically to the flexible circuit board (14) and the flexible circuit board (14) can be positioned on a bearing surface of the device (12) for retaining the flexible circuit board, **characterized in that** the further device (20-28) and the component (30-34) are provided on the same side of the circuit board (14) as the bearing surface of the device (12) for retaining the flexible circuit board.

2. The holder (10) as claimed in claim 1, **characterized in that** the component (30) forms an electrical connection.

3. The holder (10) as claimed in claim 1 or 2, **characterized in that** the component (32) forms an active element.

4. The holder (10) as claimed in claim 3, **characterized in that** the active element (32) is a sensor.

5. The holder (10) as claimed in claim 4, **characterized in that** the sensor (32) is a displacement, a speed and/or a temperature sensor.

6. The holder (10) as claimed in one of the preceding claims, **characterized in that** the component (34) has a leadframe (40).

7. The holder (10) as claimed in one of the preceding claims, **characterized by** the provision of a component (36, 38) which has a strain relief device (26).

8. The holder (10) as claimed in one of the preceding claims, **characterized by** the provision of a component (36) which provides an antikink means (60).

9. The holder (10) as claimed in one of the preceding claims, **characterized in that** the further device (20-28) essentially secures the position of the component (30-34) in relation to the holder (10).

10. The holder (10) as claimed in one of claims 7 to 9, **characterized in that** the further device (26-28) essentially secures the position of the component (36, 38) in relation to the holder (10).

11. The holder (10) as claimed in one of claims 7 to 9, **characterized in that** the connection between the component (36, 38) and the holder (10), the connection being created by means of the further device (26, 28), is releasable.

12. The holder (10) as claimed in one of the preceding claims, **characterized in that** the further device (20, 26, 28) is a latching device (26, 28) and/or a plug-in device (20).

13. The holder (10) as claimed in one of the preceding claims, **characterized in that** the further device (28) has a guide for electrical connections (42).

14. The holder (10) as claimed in one of claims 7 to 13, **characterized in that** the component (38) has a guide for electrical connections (72).

## Revendications

1. Support (10) comprenant un dispositif (12) d'attache d'une carte de circuits imprimés flexible (14), le support (10) étant en une partie et comprenant au moins un autre dispositif (20-28) d'attache d'au moins un composant (30-34, dans lequel ledit composant (30-34) est apte à être raccordé par voie électrique à ladite carte de circuits imprimés flexible (14) et ladite carte de circuits imprimés flexible (14) est apte à être positionnée sur une surface d'appui dudit dispositif (12) d'attache de ladite carte de circuits imprimés flexible, **caractérisé en ce que** ledit autre dispositif (20-28) et ledit composant (30-34) sont disposés du même côté de ladite carte de circuits imprimés flexible (14) que ladite surface d'appui dudit dispositif (12) d'attache de ladite carte de circuits imprimés flexible.

2. Support (10) selon la revendication 1, **caractérisé en ce que** ledit composant (30) constitue un connecteur électrique.

3. Support (10) selon la revendication 1 ou 2, **caractérisé en ce que** ledit composant (32) constitue un composant actif.

4. Support (10) selon la revendication 3, **caractérisé en ce que** ledit composant (32) est un capteur.

5. Support (10) selon la revendication 4, **caractérisé en ce que** ledit capteur (32) est un capteur de distance, de nombre de tours et/ou de température.

6. Support (10) selon une quelconque des revendications précédentes, **caractérisé en ce que** ledit composant (34) comprend un grillage estampé (40).

7. Support (10) selon une quelconque des revendications précédentes, **caractérisé en ce qu'**un composant (36, 38) est disposé, qui est muni d'un soulagement de traction (26).

8. Support (10) selon une quelconque des revendications précédentes, **caractérisé en ce qu'**un composant (36) est disposé, qui met à disposition une protection (60) contre le flambage.

9. Support (10) selon une quelconque des revendications précédentes, **caractérisé en ce que** ledit autre dispositif (20-28) essentiellement définit la position dudit composant (30-34) relativement audit support (10).

10. Support (10) selon une quelconque des revendications 7 à 9, **caractérisé en ce que** ledit autre dispositif (26-28) essentiellement définit la position dudit composant (36, 38) relativement audit support (10).

11. Support (10) selon une quelconque des revendications 7 à 9, **caractérisé en ce que** la connexion créée entre ledit composant (36, 38) et ledit support (10) moyennant ledit autre composant (26, 28) est détachable.

12. Support (10) selon une quelconque des revendications précédentes, **caractérisé en ce que** ledit autre composant (20, 26, 28) est un moyen à crans (26, 28) et/ou un moyen embrochable (20).

13. Support (10) selon une quelconque des revendications précédentes, **caractérisé en ce que** ledit autre composant (28) comprend un guide pour des connexions électriques (42).

14. Support (10) selon une quelconque des revendications 7 à 13, **caractérisé en ce que** ledit composant (38) comprend un guide pour des connexions électriques (72).
